# EUROPEAN PATENT APPLICATION

(11) **EP 2 858 119 A1**
(43) Date of publication of application: **08.04.2015**
(21) Application number: 13796513.3
(22) Date of filing: 28.05.2013
(51) Int. Cl.: H01L 31/04

(54) **PRODUCTION METHOD FOR COMPOUND SEMICONDUCTOR THIN FILM, AND SOLAR CELL PROVIDED WITH SAID COMPOUND SEMICONDUCTOR THIN FILM**

(30) Priority: 30.05.2012 JP 2012123783
(71) Applicant: Toppan Printing Co., Ltd., Tokyo 110-0016 (JP); Tokyo Institute of Technology, Tokyo 152-8500 (JP); Ryukoku University, Kyoto-shi, Kyoto 612-8577 (JP)
(72) Inventor: ZHANG, Yiwen, Tokyo 110-0016 (JP); YAMADA, Akira, Tokyo 152-8550 (JP); WADA, Takahiro, Otsu-shi Shiga 520-2194 (JP)
(74) Representative: TBK
(86) International application number: PCT/JP2013/064794
(87) International publication number: WO 2013/180137

(57) **Abstract**

A method is characterized by including the steps of performing a coating or printing of ink for producing a compound semiconductor thin film so as to form a compound semiconductor coating film, the ink including 50% by mass or more of amorphous compound nanoparticles, mechanically applying a pressure to the compound semiconductor coating film, and subjecting the compound semiconductor coating film to a heat-treatment to form a compound semiconductor thin film.

## Description

### Technical Field

The present invention relates to a method for producing a compound semiconductor thin film, and a solar cell including the compound semiconductor thin film.

### Background Art

A solar cell is a device which converts light energy to electric energy by utilizing a photovoltaic effect, and has recently been focused on in the context of preventing global warming and because it does not deplete natural resources. As a semiconductor used in the solar cell, monocrystal Si, polycrystal Si, amorphous Si, CdTe, CuIn₁₋ₓGaₓSe₂ (hereinafter also referred to as "CIGS"), Cu₂ZnSn(S,Se)₄ (hereinafter also referred to as "CZTS"), GaAs, InP, and the like are known.

CIGS is an acronym of Cu (copper), In (indium), Ga (gallium), and Se (selenide), which are elements forming it. CIS, which does not include Ga, is also known as a semiconductor compound used for solar cells. CZTS is an acronym of Cu (copper), Zn(zinc), Sn (tin), and S (sulfide), which are elements forming it. The composition of CZTS is not limited to Cu₂ZnSn(S,Se)₄, and CZTS including no S or no Se is also called CZTS. Cu₂ZnSn(S,Se)₄ may be sometimes written as CZTSSe, but both are included in CZTS in the present specification.

Of these, a solar cell having a chalcogenide thin film, represented by CuIn₁₋ₓGaₓSe₂, or Cu₂ZnSn(S,Se)₄, is characterized by having a high light absorption coefficient, a band-gap energy (1.4 to 1.5 eV) suitable for solar cells, and a reduced deterioration with time, and thus is attracting much attention. At present, a CIGS thin film solar cell has already entered commercial service, and research and development of a CZTS solar cell has also progressed.

Methods for producing a chalcogenide thin film solar cell are basically divided into vacuum processes (such as vapor deposition methods and sputtering methods) and non-vacuum processes, such as coating, printing, or the like. In particular, the non-vacuum process has characteristics such as a high material utilization rate, a high throughput speed, and easy increase of area, thus is receiving much attention as a low cost production method. It is known, however, that a chalcogenide film produced by the non-vacuum process has a low compactness and many voids in the film, and thus the photoelectric conversion efficiency of the solar cell is low.

In order to solve the problem described above, pressure sintering methods have been proposed (see Jpn. Pat. Appln. KOKAI Publication No. 2011-187920, Jpn. Pat. Appln. KOKAI Publication No. 2011-091305, Jpn. Pat. Appln. KOKAI Publication No. 2011-091306, and Jpn. Pat. Appln. KOKAI Publication No. 2011-192862). Pressure sintering can improve the compactness of a film, make the surface flat, and improve the photoelectric conversion efficiency. According to the pressure sintering method, however, the particles in the film insufficiently fusion-bond to each other even if the pressure sintering is performed, a surface roughness Ra cannot be decreased, there are many crystal grain boundaries having many defects, and voids remain in the film, because the method uses particles having a high degree of crystallinity as the compound particles. For such reasons, the chalcogenide thin film solar cell produced by the pressure sintering method has a conversion efficiency of only about 3.2%.

### Summary of Invention

### Problem to be Solved by the Invention

The object of the present invention is to provide a method for highly productively producing a compound semiconductor thin film having a low amount of crystal grain boundaries, a small surface roughness Ra, and a high compactness; and a solar cell including the compound semiconductor thin film.

### Means for Solving the Problem

A first aspect of the present invention provides a method for producing a compound semiconductor thin film, comprising the steps of:
performing a coating or printing of ink for producing a compound semiconductor thin film so as to form a compound semiconductor coating film, the ink including 50% by mass or more of amorphous compound nanoparticles;
mechanically applying a pressure to the compound semiconductor coating film; and
subjecting the compound semiconductor coating film to a heat treatment to form a compound semiconductor thin film.

In the method for producing a compound semiconductor thin film according to the first aspect of the present invention, it is possible to adjust the pressure in the step of mechanically applying the pressure to the compound semiconductor coating film to 0.1 MPa or more and 25 MPa or less, and the heat-treatment temperature in the step of subjecting the compound semiconductor coating film to the heat-treatment to 200°C or higher and 550°C or lower.

A second aspect of the present invention provides a method for producing a compound semiconductor thin film, comprising the steps of:
performing a coating or printing of ink for producing a compound semiconductor thin film so as to form a compound semiconductor coating film, the ink including 50% by mass or more of amorphous compound nanoparticles; and
subjecting the compound semiconductor coating film to a heat-treatment while a pressure is mechanically applied to the film to form a compound semiconductor thin film.

In the method for producing a compound semiconductor thin film according to the second aspect of the present invention, it is possible to adjust the pressure in the step of subjecting the compound semiconductor coating film to a heat-treatment while a pressure is mechanically applied to the film to 0.1 MPa or more and 25 MPa or less, and the heating temperature to 200°C or higher and 550°C or lower.

The compound semiconductor thin film obtained by the method for producing a compound semiconductor thin film according to the first or second aspect of the present invention is characterized by having a surface roughness Ra of 100 nm or less. It is possible, as the compound nanoparticles, to use particles including elements of at least two or more groups selected from the group consisting of group IB elements, group IIIB elements, and group VIB elements.

It is possible, as the compound nanoparticles, to use particles of at least one compound selected from the group consisting of compounds represented by CuInₓGa₁₋ₓSe₂ (0 ≤ x ≤ 1), AgInₓGa₁₋ₓSe₂ (0 ≤ x ≤ 1), CuInₓGa₁₋ₓ (Se_{y}S_{1-y})₂ (0 ≤ x ≤ 1 and 0 ≤ y ≤ 1), and CuAl(SeₓS₁₋ₓ)₂ (0 ≤ x ≤ 1).

It is also possible, as the compound nanoparticles, to use particles of at least one compound selected from the group consisting of compounds represented by Cu₂₋ₓSe_{1-y}S_{y} (0 ≤ x ≤ 1 and 0 ≤ y ≤ 1), (InₓGa₁₋ₓ)₂(Se_{1-y}S_{y})₃ (0 ≤ x ≤ 1 and 0 ≤ y ≤ 1), and InₓGa₁₋ₓSe_{1-y}S_{y} (0 ≤ x < 1 and 0 ≤ y ≤ 1).

Alternatively, it is possible, as the compound nanoparticles, to use particles including elements of at least two groups selected from the group consisting of group IB elements, group IIB elements, group IVB elements, and group VIB elements.

It is possible, as the compound nanoparticles, to use particles of a compound represented by Cu₂₋ₓZn_{1+y}SnS_{z}Se_{4-z} (0 ≤ x 1, 0 ≤ y ≤ 1, and 0 ≤ z ≤ 4).

It is also possible, as the compound nanoparticles, to use particles of at least one compound selected from the group consisting of compounds represented by Cu₂₋ₓS_{y}Se_{2-y} (0 ≤ x ≤ 1 and 0 ≤ y ≤ 2), Zn₂₋ₓS_{y}Se_{2-y} (0 ≤ x ≤ 1 and 0 ≤ y ≤ 2), and Sn₂₋ₓS_{y}Se_{2-y} (0 ≤ x ≤ 1 and 0 ≤ y ≤ 2).

It is possible, as the compound nanoparticles, to use particles synthesized at -67°C or higher and 25°C or lower.

It is also possible, as the compound nanoparticles, to use particles having an average particle size of 1 nm or more and 500 nm or less.

A third aspect of the present invention provides a solar cell including a compound semiconductor thin film produced by the method for producing a compound semiconductor thin film according to any of the first and second aspects of the present invention.

### Effect of the Invention

According to the present invention, a method for producing a compound semiconductor thin film having a good compactness in a high productivity environment, which can be mass-produced in an industrial scale; and a solar cell including the compound semiconductor thin film are provided.

### Brief Description of Drawings

FIG. 1 is a vertical cross-sectional side view showing schematically a structure of a solar cell according to an embodiment of the present invention;
FIG. 2 is a view showing X-ray diffraction patterns of nanoparticles used in Examples 1 and 2;
FIG. 3 is a view showing SEM photographs of cross-sections of light-absorbing layers 103 obtained in Examples 1 and 2;
FIG. 4 is a view showing SEM photographs of cross-sections of light-absorbing layers 103 obtained in Comparative Examples 1 and 2;
FIG. 5 is a view showing an SEM photograph of a cross-section of a light-absorbing layer 103 obtained in Comparative Example 3; and
FIG. 6 is a view showing SEM photographs of surfaces of light-absorbing layers 103 obtained in Examples 3 and 4, and Comparative Example 4.

### Modes for Carrying Out the Invention

An embodiment of the present invention will be explained referring to the drawings.

The present inventors have conducted much research on the formation of a compound semiconductor thin film by a so-called non-vacuum process, in which a coating film, obtained by a coating or printing of ink including compound nanoparticles, is subjected to a heat-treatment; as a result, they have found that when a pressure is mechanically applied to a coating film, obtained from an ink for producing a compound semiconductor thin film, including compound nanoparticles mainly made of an amorphous substance, and thereafter performing a heat-treatment, a compact compound semiconductor thin film can be formed.

They have also found that, instead of the procedure in which the pressure is mechanically applied to the coating film followed by subjecting the film to the heat-treatment, a compact compound semiconductor thin film can be formed by subjecting the coating film to the heat-treatment while the pressure is mechanically applied to the film.

In addition, the present inventors have found that when the compact compound semiconductor thin film formed in the method described above is used as a light-absorbing layer (photoelectric conversion layer) of a solar cell, a solar cell having a high conversion efficiency can be obtained.

The present invention has been accomplished based on the findings described above.

A method for producing a compound semiconductor thin film according to a first embodiment of the present invention is characterized by comprising the steps of: performing a coating or printing of ink for producing a compound semiconductor thin film so as to form a compound semiconductor coating film, the ink including 50% by mass or more of amorphous compound nanoparticles; mechanically applying a pressure to the compound semiconductor coating film; and subjecting the compound semiconductor coating film to a heat treatment to form a compound semiconductor thin film.

A method for producing a compound semiconductor thin film according to a second embodiment of the present invention is characterized by comprising the steps of: performing a coating or printing of ink for producing a compound semiconductor thin film so as to form a compound semiconductor coating film, the ink including 50% by mass or more of amorphous compound nanoparticles; and subjecting the compound semiconductor coating film to a heat-treatment while a pressure is mechanically applied to the film to form a compound semiconductor thin film.

In the methods for producing a compound semiconductor thin film according to the first and second embodiments of the present invention, the compound nanoparticles as a starting material include 50% by mass or more of an amorphous compound nanoparticles, in other words, the starting material is compound nanoparticles mainly made of an amorphous substance. The phrase "mainly made of an amorphous substance" means that it is not necessary for the nanoparticles to be completely made of the amorphous substance, and such may partly include a crystalline substance. It is necessary, however, that the amorphous substance accounts for 50% by mass or more of the nanoparticles, and the amorphous substance is preferably accounts for 70% by mass or more. It is possible, accordingly, that, for example, less than 50% by mass, preferably less than 30% by mass, of the crystalline particles are mixed with the amorphous particles.

When compound nanoparticles including a large amount (more than 50% by mass) of a crystalline substance, that is, which is not mainly made of the amorphous substance, are used, it is difficult to fusion-bond the particles to each other even if the particles are pressurized and heat-treated, because such compound particles are energy stable. Even after the particles are pressurized and heat-treated, accordingly, the surface roughness is not decreased, there are many crystal grain boundaries having many defects, and voids remain in the film. For that reason, a photoelectric conversion efficiency of a solar cell produced using such compound nanoparticles is insufficiently improved.

On the other hand, when the compound nanoparticles having a small amount of crystalline substance, which is mainly made of the amorphous substance, is used, the particles are easily fusion-bonded to each other, and there are only a few grain boundaries, and a compound semiconductor having a high compactness is obtained, and thus a photoelectric conversion efficiency of a solar cell produced using such compound nanoparticles is improved.

It is possible, as the compound nanoparticles, to use particles including elements of at least two or more groups selected from the group consisting of group IB elements, group IIIB elements, and group VIB elements.

It is possible, as such compound nanoparticles, to use particles of at least one compound selected from the group consisting of compounds represented by CuInₓGa₁₋ₓSe₂ (0 ≤ x ≤ 1), AgInₓGa₁₋ₓSe₂ (0 ≤ x ≤ 1), CuInₓGa₁₋ₓ(Se_{y}S_{1-y})₂ (0 ≤ x ≤ 1 and 0 ≤ y ≤ 1), and CuAl(SeₓS₁₋ₓ)₂ (0 ≤ x ≤ 1).

It is also possible to use particles of at least one compound selected from the group consisting of compounds represented by Cu₂₋ₓSe_{1-y}S_{y} (0 ≤ x ≤ 1 and 0 ≤ y ≤ 1), (InₓGa₁₋ₓ)₂(Se_{1-y}S_{y})₃ (0 ≤ x ≤ 1 and 0 ≤ y ≤ 1), and InₓGa₁₋ₓSe_{1-y}S_{y} (0 ≤ x ≤ 1 and 0 ≤ y ≤ 1).

The reaction of the nanoparticles of the compound represented by Cu₂₋ₓSe_{1-y}S_{y} (0 ≤ x ≤ 1 and 0 ≤ y ≤ 1) with the nanoparticles of the compound represented by (InₓGa₁₋ₓ)₂(Se_{1-y}S_{y})₃ (0 ≤ x ≤ 1 and 0 ≤ y ≤ 1) is an exothermic reaction, and thus an effect of promoting crystal growth is generated utilizing the heat of reaction.

Alternatively, it is possible, as the compound nanoparticles, to use particles including elements of at least two groups selected from the group consisting of group IB elements, group IIB elements, group IVB elements, and group VIB elements.

It is possible, as such compound nanoparticles, to use particles of a compound represented by Cu₂₋ₓZn_{1+y}SnS_{z}Se_{4-z} (0 ≤ x ≤ 1, 0 ≤ y ≤ 1, and 0 ≤ z ≤ 4).

It is also possible to use particles of at least one compound selected from the group consisting of compounds represented by Cu₂₋ₓS_{y}Se_{2-y} (0 ≤ x ≤ 1 and 0 ≤ y ≤ 2), Zn₂₋ₓS_{y}Se_{2-y} (0 ≤ x ≤ 1 and 0 ≤ y ≤ 2), and Sn₂₋ₓS_{y}Se_{2-y} (0 ≤ x ≤ 1 and 0 ≤ y ≤ 2).

The reaction of the nanoparticles of the compound represented by Cu₂₋ₓS_{y}Se_{2-y} (0 ≤ x ≤ 1 and 0 ≤ y ≤ 2), or Zn₂₋ₓS_{y}Se_{2-y} (0 ≤ x ≤ 1 and 0 ≤ y ≤ 2) with the nanoparticles of the compound represented by Sn₂₋ₓS_{y}Se_{2-y} 0 ≤ x ≤ 1 and 0 ≤ y ≤ 2) is an exothermic reaction, and thus an effect of promoting crystal growth is generated utilizing the heat of reaction.

The synthetic reaction temperature of such compound nanoparticles is desirably -67°C or higher and 25°C or lower. When the synthetic reaction temperature is higher than 25°C, the reaction speed is fast, and crystallizability (degree of crystallinity) of the obtained compound particles tends to be increased. When the synthetic reaction temperature is lower than -67°C, the reaction speed is slow, and the synthetic reaction time tends to become longer. The synthetic reaction temperature is more preferably -5°C or higher and 5°C or lower.

The compound nanoparticles used in the present embodiment have preferably an average particle size of 1 nm or more and 500 nm or less. When the average particle size of the compound nanoparticles is more than 500 nm, voids are easily generated in the compound semiconductor thin film in the heat-treatment step of the compound semiconductor thin film, and the surface roughness Ra is increased. As a result, the photoelectric conversion efficiency of the solar cell including the compound semiconductor thin film tends to be decreased.

On the other hand, when the average particle size of the compound nanoparticles is less than 1 nm, the fine particles are easily aggregated, and it is difficult to prepare an ink. The average particle size of the compound particles is more preferably 2 nm or more and 200 nm or less.

The average particle size of the compound nanoparticles refers to the average minimum diameter of the compound particles, obtained by the observation using an SEM (scanning electron microscope) or a TEM (transmission electron microscope).

The compound nanoparticles, as described above, are dispersed in an organic solvent, whereby an ink for forming a compound semiconductor thin film, used in the step of forming the compound semiconductor coating film of the embodiment can be prepared.

The organic solvent is not particularly limited, and, for example, alcohols, ethers, esters, aliphatic hydrocarbons, alicyclic hydrocarbons, aromatic hydrocarbons, nitrogen-containing aromatic hydrocarbons, heterocyclic compounds, and the like may be used. The organic solvents may include preferably alcohols having less than 10 carbon atoms such as methanol, ethanol and butanol, diethyl ether, pentane, hexane, cyclohexane, and toluene, particularly preferably methanol, pyridine, toluene, and hexane.

In order to effectively disperse the compound particles in the organic solvent, a dispersing agent may be added to the ink for forming the compound semiconductor thin film. The dispersing agent may include thiols, selenols, alcohols having 10 or more carbon atoms, and the like.

It is also possible to add a binder to the ink for forming the compound semiconductor thin film, in order to obtain a compact semiconductor thin film. Se particles, S particles, Se compounds, or S compounds may be used as the binder. The S compound may include preferably thiourea. The concentration of the solid component in the organic solvent is not particularly limited, and is usually from 1 to 20% by mass.

The thus prepared ink for forming the compound semiconductor thin film is coated or printed on a substrate and dried, and then the organic solvent is removed therefrom, whereby the compound semiconductor coating film can be formed. The coating method may include doctor methods, spin coating methods, slit coating methods, spray methods, and the like; and the printing method may include gravure printing methods, screen printing methods, reverse offset printing methods, relief printing methods, and the like.

The film thickness of the coating film formed by coating or printing is preferably adjusted so that after drying, pressurizing and heat-treating it, the compound semiconductor thin film has a film thickness of 0.5 µm or more and 10 µm or less, for example, about 2 µm.

To the thus formed compound semiconductor coating film is mechanically applied a pressure. As a method of mechanically applying a pressure, for example, it is possible to use a plane pressurization method or a roll pressurization method. The roll pressurization method can deal with not only plane substrates but also flexible substrates. As the roll, non-metal rolls such as rubber rolls and plastic rolls, metal rolls such as stainless steel rolls and aluminum rolls can be used.

The pressure to be mechanically applied is preferably within a range of 0.1 MPa or more and 25 MPa or less. When the pressure is less than 0.1 MPa, effects obtained by the pressurization tends to be insufficient. When the pressure is more than 25 MPa, the compound thin film tends to be destroyed.

The step of mechanically applying a pressure can be performed at a temperature of an ordinary temperature (25°C) or higher and 550°C or lower.

According to the method of the first embodiment of the present invention, after the step of mechanically applying a pressure, the step of the heat-treatment is performed. The heat-treatment temperature is 200°C or higher and 550°C or lower. When the heat-treatment temperature is higher than 550°C, the compound semiconductor thin film may sometimes be destroyed.

The heat-treatment can be performed in at least one atmosphere selected from the group consisting of an H₂S atmosphere, an H₂Se atmosphere, an Se atmosphere, an S atmosphere, a forming gas atmosphere, an Sn atmosphere, and In atmosphere. In the heat-treatment step, S or Se in the thin film evaporates, and thus the atmosphere including S or Se is desirable.

In the method according to the second embodiment of the present invention, the step in which the film is subjected to the heat-treatment while a pressure is mechanically applied to the film is performed. The pressure in this step can be the same as that in the first embodiment, that is, 0.1 MPa or more and 25 MPa or less; and the heat-treatment temperature can be the same as that in the heat-treatment step after the step of applying a pressure in the first embodiment, that is, 200°C or higher and 550°C or less. The atmosphere can also be the same as that in the heat-treatment step in the first embodiment, that is, at least one atmosphere selected from the group consisting of an H₂S atmosphere, an H₂Se atmosphere, an Se atmosphere, an S atmosphere, a forming gas atmosphere, an Sn atmosphere, and In atmosphere.

The compound semiconductor thin film having the good compactness can be formed with high productivity in the manner as described above.

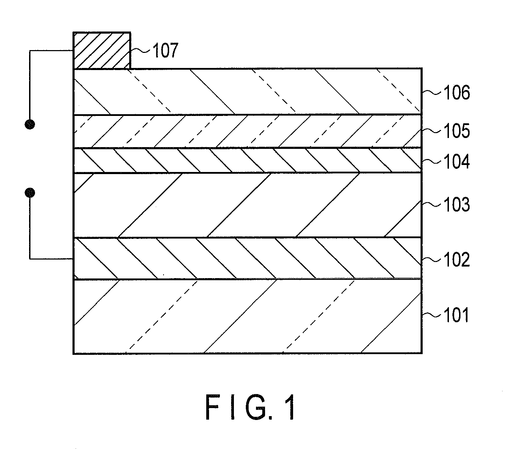

A structure of a solar cell according to a third embodiment of the present invention, which includes the compound semiconductor thin film described above, is explained below, referring to FIG. 1.

FIG. 1 is a cross-sectional side view schematically showing a structure of a solar cell according to a third embodiment of the present invention. In the solar cell shown in FIG. 1, a back electrode 102 is formed on a substrate 101. For the substrate 101, soda-lime glass, a metal plate, or a plastic film can be used. For the back electrode 102, a metal such as molybdenum (Mo), nickel (Ni) or copper (Cu) can be used.

The compound semiconductor thin film, described above, is formed on the back electrode 102 as a light-absorbing layer 103, that is, the light-absorbing layer 103 is formed by coating the ink for forming the compound semiconductor thin film on the back electrode 102, drying it, subjecting it to the pressurization treatment, and subjecting it to the heat-treatment.

A buffer layer 104, a layer i 105, and a layer n 106 are formed in order on the light-absorbing layer 103. For the buffer layer 104, known CdS, Zn(S,O,OH), or In₂S₃ can be used. For the layer i 105, a known metal oxide such as ZnO can be used. In addition, for the layer n 106, known ZnO to which Al, Ga, or B is added can be used.

Subsequently, a surface electrode 107 is formed on the layer n 106 to complete a solar cell. For the surface electrode 107, known metal such as Al or Ag can be used.

Although it is not shown in the drawing, it is possible to provide an antireflective film, which suppresses light reflection and plays a role in enabling more light to be absorbed in the light-absorbing layer, on the layer n 106. The material of the antireflective film is not particularly limited, and for example magnesium fluoride (MgF₂) can be used. The antireflective film has an appropriate film thickness of about 100 nm.

### [Example]

The present invention is now explained in detail based on the Examples below, but the invention is not limited to the Examples.

### Example 1

### (Synthesis of Cu-Zn-Sn-Se-S Nanoparticles)

CuI, ZnI₂, and SnI₂ were dissolved in pyridine to prepare a first solution. Na₂Se and Na₂S were dissolved in methanol to prepare a second solution. The first solution and the second solution were mixed in a ratio of Cu/Zn/Sn/Se/S = 2.5/1.5/1.25/1.85/1.85. The obtained mixture was reacted at 0°C in an inert gas atmosphere to synthesize Cu-Zn-Sn-Se-S nanoparticles.

The reaction solution was filtered, washed with methanol, and the obtained Cu-Zn-Sn-Se-S nanoparticles were dispersed in a mixed liquid of pyridine and methanol.

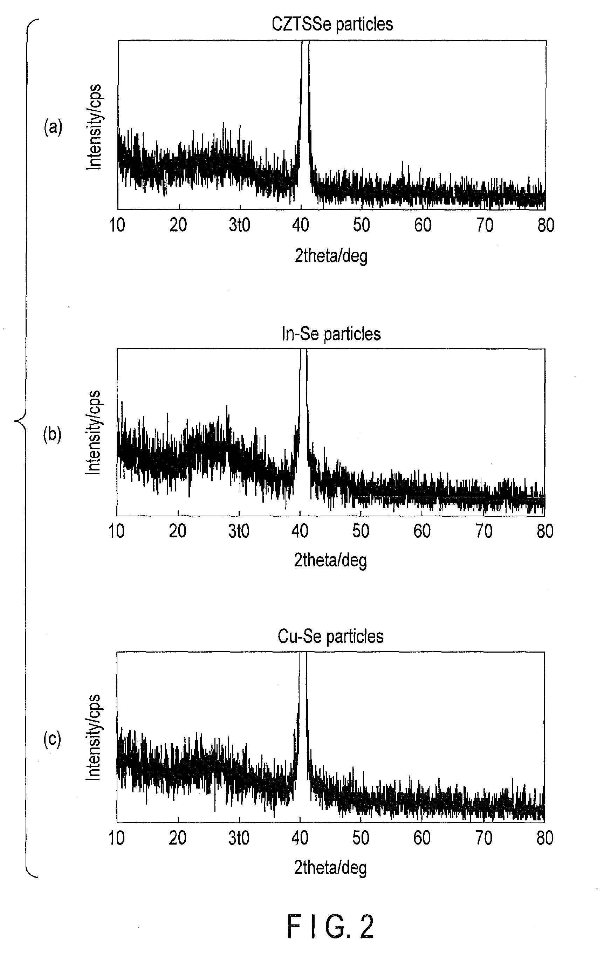

X-ray diffraction patterns of the nanoparticles are shown in FIG. 2A. It was found that no diffraction peak was detected, indicating that the nanoparticles were almost amorphous. A peak at about 40° can be assigned to the Mo substrate, on which the compound nanoparticles were coated, and no diffraction pattern resulting from the Cu-Zn-Sn-Se-S nanoparticles was detected.

### (Production of Ink)

Thiourea was added to the thus obtained dispersion of the Cu-Zn-Sn-Se-S nanoparticles. At that time, a mass ratio of the Cu-Zn-Sn-Se-S nanoparticles to the thiourea was 3 : 2. Further, methanol was added thereto so that the obtained mixture had 5% by mass of a solid component to prepare an ink for forming the compound semiconductor thin film.

Next, a solar cell having a structure shown in FIG. 1 was produced as follows:

### (Formation of Back Electrode 102)

A back electrode 102 including an Mo layer was formed on a soda-lime glass 101 using a sputtering method.

### (Formation of Light-Absorbing Layer 103)

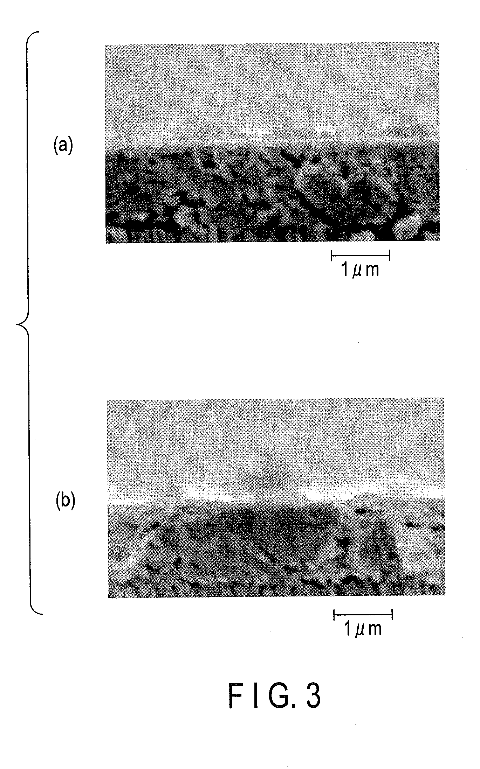

The ink for forming the compound semiconductor thin film, obtained as above, was coated on the back electrode 102 using a doctor method, and the solvent was removed in an oven at a temperature of 250°C. The obtained film was pressurized at a pressure of 6 MPa at 400°C, and then the film was heated at 500°C in a steam atmosphere of Sn and Se for 30 minutes to form a light-absorbing layer 103 having a film thickness of 2 µm. A cross-sectional SEM photograph of the obtained light-absorbing layer 103 is shown in FIG. 3A.

### (Formation of Buffer Layer 104)

The structure forming the light-absorbing layer 103 was immersed in a mixed aqueous solution including cadmium sulfate (CdSO₄), thiourea (NH₂CSNH₂), and aqueous ammonia (NH₄OH) in molar concentrations of, respectively, 0.0015 M, 0.0075 M and 1.5 M, and having a temperature of 70°C, whereby a buffer layer 104 having a film thickness of 50 nm and made of CdS was formed on the light-absorbing layer 103.

### (Formation of Layer i 105)

A layer i 105 having a thickness of 50 nm and made of ZnO was formed on the buffer layer 104 from diethylzinc and water as starting materials, using an MOCVD method (a metal organic chemical vapor deposition).

### (Formation of Layer n 106)

A layer n 106 having a thickness of 1 µm and made of ZnO : B was formed on the layer i 105 from diethyl zinc, water and diborane as starting materials, using the MOCVD method.

### (Formation of Surface Electrode 107)

A surface electrode 107 having a thickness of 0.3 µm and made of Al was formed on the layer n 106, using a vapor deposition method, whereby a solar cell having the structure shown in FIG. 1 was completed.

### Example 2

### (Synthesis of Cu-Se Nanoparticles)

A solution in which CuI was dissolved in pyridine was mixed with a solution in which Na₂Se was dissolved in methanol, and the mixture was reacted at 0°C in an inert gas atmosphere to synthesize Cu-Se nanoparticles.

The reaction solution was filtered and washed with methanol. After that, the obtained Cu-Se nanoparticles were dispersed in a mixed liquid of pyridine and methanol.

Patterns of the nanoparticles, analyzed by the X-ray powder diffraction, are shown in FIG. 2B. As shown in FIG. 2B, it was found that crystal peaks were not detected, and the nanoparticles were almost amorphous. A peak at about 40° was a peak resulting from the Mo substrate, which coated the compound nanoparticles, and a diffraction pattern resulting from the Cu-Se was not detected.

### (Synthesis of In-Se Nanoparticles)

A solution in which InI₃ was dissolved in pyridine was mixed with a solution in which Na₂Se was dissolved in methanol, and the mixture was reacted at 0°C in an inert gas atmosphere to synthesize In-Se nanoparticles.

The reaction solution was filtered and washed with methanol. After that, the obtained In-Se nanoparticles were dispersed in a mixed liquid of pyridine and methanol.

Patterns of the nanoparticles, analyzed by the X-ray powder diffraction, are shown in FIG. 2C. As shown in FIG. 2C, it was found that crystal peaks were not detected, and the nanoparticles were almost amorphous. A peak at about 40° was a peak resulting from the Mo substrate, which coated the compound nanoparticles, and a diffraction pattern resulting from the InSe was not detected.

### (Production of Ink)

The thus obtained liquid including Cu-Se nanoparticles disperse was mixed with the liquid dispersion including In-Se nanoparticles, and thiourea was added thereto as a binder including an S atom. The preparation was performed so that a molar ratio of Cu/In/Se/S is 0.8/1/1.9/0.5. Further, methanol was added to the mixture so that the obtained mixture had a solid concentration of 5% by mass, whereby an ink was produced.

Subsequently, a solar cell having the structure shown in FIG. 1 was produced in the same manner as in Example 1 except that the light-absorbing layer 103 was formed as described below.

### (Formation of Light-Absorbing Layer 103)

The ink for forming the compound semiconductor thin film obtained as above was coated on the back electrode 102 by a doctor method, and the solvent was evaporated in an oven at a temperature of 250°C. The obtained coating film was pressurized at a pressure of 6 MPa at 400°C, and then the film was heated at 550°C for 60 minutes in an Se steam atmosphere to form a light-absorbing layer 103 having a film thickness of 2 µm and made of CIS. A cross-sectional SEM photograph of the obtained light-absorbing layer 103 is shown in FIG. 3B.

### Comparative Example 1

A CZTS solar cell was obtained in the same manner as in Example 1 except that the pressurization step was omitted in the formation of the light-absorbing layer 103.

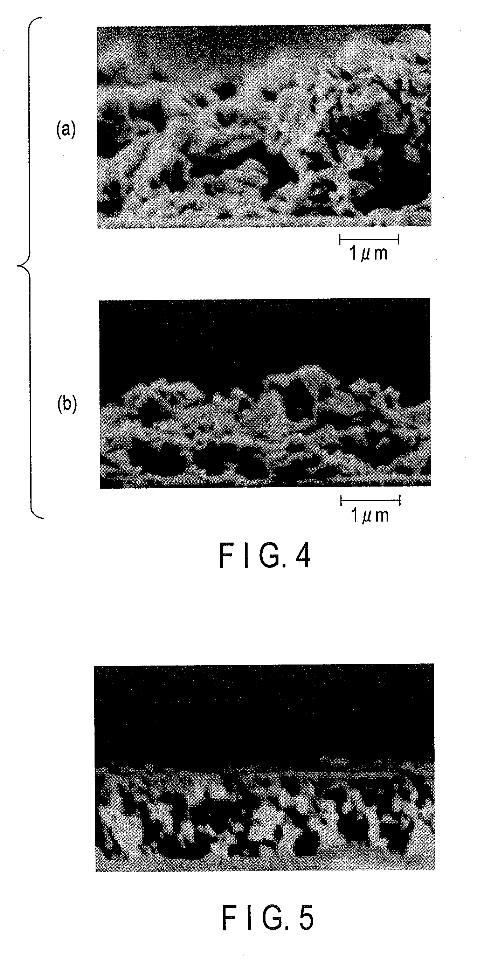

A cross-sectional SEM photograph of the obtained light-absorbing layer 103 is shown in FIG. 4A.

### Comparative Example 2

A CIS solar cell was obtained in the same manner as in Example 2 except that the pressurization step was omitted in the formation of the light-absorbing layer 103.

A cross-sectional SEM photograph of the obtained light-absorbing layer 103 is shown in FIG. 4B.

### Comparative Example 3

### (Synthesis of CZTS Particles according to Mechanochemical Method)

A Powder of elements Cu, Zn, Sn and Se were weighed and mixed so that the atomic ratio thereof is Cu₂Zn_{1.2}Sn_{0.8}Se₄. To the obtained mixture was added 0.5% by mol (corresponding to 0.005 mol based on 1 mol of CU₂Zn_{1.2}Sn_{0.8}Se₄) of NaF.

In a 45 cc zirconium container of a planet ball mill were put 20 g of the weighed powder and 40 g of round balls having a diameter of 3 mm, and the mixture was stirred at 800 rpm for 20 minutes in a nitrogen atmosphere. A mechanochemical reaction was caused by the stirring to obtain a powder including Cu₂Zn_{1.2}Sn_{0.8}Se₄ as a main component.

The powder was found to be crystalline by analyzing it according to the X-ray powder diffraction.

### (Production of Ink)

To the obtained powder including Cu₂Zn_{1.2}Sn_{0.8}Se₄ as a main component was added 13 ml of ethyleneglycol monophehyl ether to produce an ink for forming the compound semiconductor thin film.

Subsequently, a solar cell having the structure shown in FIG. 1 was produced in the same manner as in Example 1 except that the light-absorbing layer 103 was formed as described below.

### (Formation of Light-Absorbing Layer 103)

The ink for forming the compound semiconductor thin film obtained as above was coated on the back electrode 102 by a doctor method, and the solvent was evaporated in an oven at a temperature of 250°C. The obtained coating film was pressurized at a pressure of 6 MPa at 400°C, and then the film was heated at 500°C for 30 minutes in an Se and S steam atmosphere to form a light-absorbing layer 103 having a film thickness of 2 µm and made of the Cu-Zn-Sn-S compound. A cross-sectional SEM photograph of the obtained light-absorbing layer 103 is shown in FIG. 5.

### Example 3

The amorphous particles of Cu-Zn-Sn-S-Se obtained in Example 1 was mixed with the crystalline particles of Cu-Zn-Sn-Se obtained in Comparative Example 3 in a mass ratio of 80 : 20. To 10 parts by mass of the obtained mixture was added 6 parts by mass of ethyleneglycol monophenyl ether to produce an ink for forming the compound semiconductor thin film.

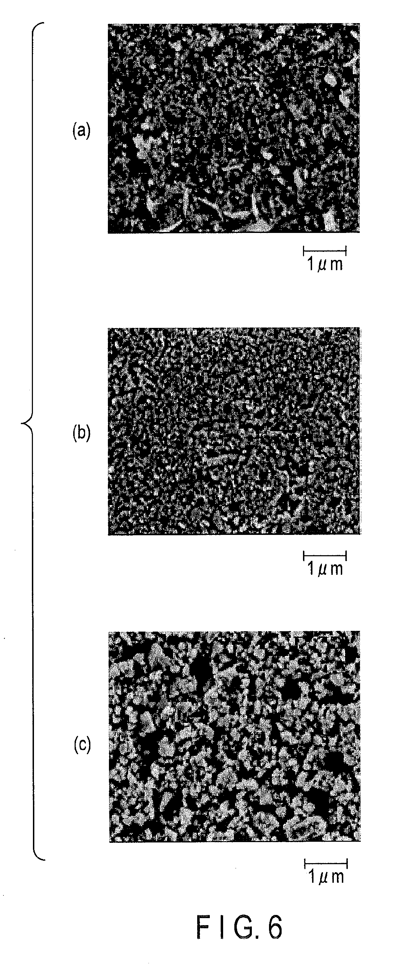

The ink for forming the compound semiconductor thin film obtained as above was coated on the back electrode 102 by a screen printing method, and the solvent was evaporated in an oven at a temperature of 250°C. The obtained coating film was pressurized at a pressure of 6 MPa at 350°C, and then the film was heated at 500°C for 30 minutes in an Se steam atmosphere to form a light-absorbing layer 103 having a film thickness of 2 µm and made of the Cu-Zn-Sn-Se-S compound. A cross-sectional SEM photograph of the obtained light-absorbing layer 103 is shown in FIG. 6A.

### Example 4

A light-absorbing layer 103 was formed in the same manner as in Example 3 except that a mixing ratio of the amorphous particles of Cu-Zn-Sn-S-Se and the crystalline particles of Cu-Zn-Sn-Se was changed to 60 : 40. A cross-sectional SEM photograph of the obtained light-absorbing layer 103 is shown in FIG. 6B.

### Comparative Example 4

A light-absorbing layer 103 was formed in the same manner as in Example 3 except that a mixing ratio of the amorphous particles of Cu-Zn-Sn-S-Se and the crystalline particles of Cu-Zn-Sn-Se was changed to 40 : 60. A cross-sectional SEM photograph of the obtained light-absorbing layer 103 is shown in FIG. 6C.

### (Evaluation)

The cross-sectional SEM photograph shown in FIG. 3 shows the following.

In Examples 1 and 2, the compound semiconductor coating film was formed using the ink including the compound nanoparticles, which was mainly made of the amorphous substance, and the film was pressurized and heat-treated to form the compound semiconductor thin film. It is found from FIG. 3A and FIG. 3B that the compound semiconductor thin films have the high compactness and have no voids.

On the other hand, the compound semiconductor thin films from Comparative Examples 1 and 2, which were obtained by subjecting to the heat-treatment alone but no pressurization, have the poor compactness, as shown in FIGS. 4A and 4B. Similarly, the compound semiconductor thin film from Comparative Example 3, which was obtained using the ink including the crystalline compound nanoparticles obtained by the mechanochemical method, also has the poor compactness, as shown in FIG. 5.

The surface SEM photographs of the compound semiconductor thin films from Examples 3 and 4, and Comparative Example 4 are shown respectively in FIG. 6A, FIG. 6B, and FIG. 6C. The contents of the crystalline nanoparticles of Cu-Zn-Sn-S in the ink in Examples 3 and 4 are, respectively, 20% by mass and 40% by mass of the compound nanoparticles, that is, the inks used in Examples 3 and 4 have 50% by mass or more, of the compound nanoparticles, of the amorphous substance. In such Examples 3 and 4, the compact films were obtained after the pressurization and the heat-treatment.

On the other hand, when the ink including 60% by mass, of the compound nanoparticles, of the crystalline particles of Cu-Zn-Sn-Se was used, as in Comparative Example 4, there were voids in the obtained film even after the pressurization and the heat-treatment.

Next, as for the compound semiconductor thin films obtained from Examples 1 and 2, and Comparative Examples 1 to 3, a surface roughness Ra of the film was measured in a scanning zone of 10 µm using an atomic force microscope, AFM (SPM-9600 manufactured Shimadzu Corporation). In addition, as for each solar cell, a photoelectric conversion efficiency was obtained using a reference solar radiation simulator (CEP-25MLT manufactured by Bunkoukeiki Co., Ltd.); a light intensity: 100 mW/cm², air mass: 1.5). The results are shown in Table 1 below.

**TABLE 1**

| | Pressurization | Surface roughness Ra (nm) | Conversion efficiency (%) |
|---|---|---|---|
| Example 1 | Plane pressurization | 37 | 2.5 |
| Example 2 | Plane pressurization | 48 | 3.1 |
| Comparative Example 1 | None | 110 | 0.6 |
| Comparative Example 2 | None | 311 | 1.4 |
| Comparative Example 3 | Plane pressurization | 104 | Measuring lower limit or less |

As shown in Table 1 above, in the compound semiconductor thin films from Examples 1 and 2, which were formed by performing the pressurization and the heat-treatment, the surface roughness Ra is remarkably decreased compared to that of the films from Comparative Examples 1 and 2, in which the pressurization and heat-treatment was not performed. It is also known that the compound semiconductor thin film from Example 1, which is made of the amorphous substance, has a smaller surface roughness Ra compared to that of the compound semiconductor thin film from Comparative Example 3, which is made of the crystalline substance.

It is further known that any of the solar cells including the compound semiconductor thin films (Examples 1 and 2), obtained by subjecting the compound semiconductor coating film including the compound nanoparticles mainly made of the amorphous substance to the pressurization and the heat-treatment, has the high conversion efficiency.

On the other hand, even if the ink including the compound nanoparticles mainly made of the amorphous substance as in Examples 1 and 2 is used, any of the solar cells including the compound semiconductor thin film obtained by subjecting the film the heat-treatment alone without the pressurization (Comparative Examples 1 and 2) has the low conversion efficiency. When the ink including the crystalline compound nanoparticles obtained by the mechanochemical method is used (Comparative Example 3), even if the compound semiconductor coating film is pressurized and heat-treated, the conversion efficiency is low as above.

When the pressurization step is not performed, and when the compound nanoparticles mainly made of the amorphous substance is not used, all of the formed compound semiconductor thin films were poor in the compactness. For this reason, such a solar cell including the compound semiconductor thin film can be assumed to have the low conversion efficiency.

### Industrial Applicability

The present invention can be utilized as a method for producing a semiconductor element including a compound semiconductor, in particular a photoelectric converting element (solar cell).

## Claims

1. A method for producing a compound semiconductor thin film, comprising the steps of:
performing a coating or printing of ink for producing a compound semiconductor thin film so as to form a compound semiconductor coating film, the ink including 50% by mass or more of amorphous compound nanoparticles;
mechanically applying a pressure to the compound semiconductor coating film; and
subjecting the compound semiconductor coating film to a heat-treatment to form a compound semiconductor thin film.

2. The method for producing a compound semiconductor thin film according to claim 1, wherein the pressure in the step of mechanically applying a pressure to the compound semiconductor coating film is 0.1 MPa or more and 25 MPa or less, a temperature in the step of applying a pressure is 25°C or higher and 550°C or lower, and a heat-treatment temperature in the step of subjecting the compound semiconductor coating film to a heat-treatment is 200°C or higher and 550°C or lower.

3. A method for producing a compound semiconductor thin film, comprising the steps of:
performing a coating or printing of ink for producing a compound semiconductor thin film so as to form a compound semiconductor coating film, the ink including 50% by mass or more of amorphous compound nanoparticles; and
subjecting the compound semiconductor coating film to a heat-treatment while a pressure is mechanically applied to the film to form a compound semiconductor thin film.

4. The method for producing a compound semiconductor thin film according to claim 1, wherein in the step of subjecting the compound semiconductor coating film to a heat-treatment while a pressure is mechanically applied to the film, the pressure is 0.1 MPa or more and 25 MPa or less, and the heating temperature is 200°C or higher and 550°C or lower.

5. The method for producing a compound semiconductor thin film according to any of claims 1 to 4, wherein the surface roughness Ra of the compound semiconductor thin film is adjusted to 100 nm or less by mechanically applying a pressure to the compound semiconductor coating film.

6. The method for producing a compound semiconductor thin film according to any of claims 1 to 4, wherein the compound nanoparticles include elements of at least two groups selected from the group consisting of group IB elements, group IIIB elements, and group VIB elements.

7. The method for producing a compound semiconductor thin film according to claim 6, wherein the compound nanoparticles are made of at least one compound selected from the group consisting of compounds represented by CuInₓGa₁₋ₓSe₂ (0 ≤ x ≤ 1), AgInₓGa₁₋ₓSe₂ (0 ≤ x ≤ 1), CuInₓGa₁₋ₓ(Se_{y}S_{1-y})₂ (0 ≤ x ≤ 1 and 0 ≤ y ≤ 1), and CuAl(SeₓS₁₋ₓ)₂ (0 ≤ x ≤ 1).

8. The method for producing a compound semiconductor thin film according to claim 6, wherein the compound nanoparticles are made of at least one compound selected from the group consisting of compounds represented by Cu₂₋ₓSe_{1-y}S_{y} (0 ≤ x ≤ 1 and 0 ≤ y < 1), (InₓGa₁₋ₓ)₂(Se_{1-y}S_{y})₃ 0 ≤ x ≤ 1 and (0 ≤ y ≤ 1), and InₓGa₁₋ₓSe_{1-y}S_{y} (0 ≤ x ≤ 1 and 0 ≤ y ≤ 1).

9. The method for producing a compound semiconductor thin film according to any of claims 1 to 4, wherein the compound nanoparticles include elements of at least two groups selected from the group consisting of group IB elements, group IIB elements, group IVB elements, and group VIB elements.

10. The method for producing a compound semiconductor thin film according to claim 9, wherein the compound nanoparticles are made of a compound represented by Cu₂₋ₓZn_{1+y}SnS_{z}Se_{4-z} (0 ≤ x ≤ 1, 0 ≤ y ≤ 1, and 0 ≤ z < 4).

11. The method for producing a compound semiconductor thin film according to claim 9, wherein the compound nanoparticles are made of at least one compound selected from the group consisting of compounds represented by Cu₂₋ₓS_{y}Se_{2-y} (0 ≤ x ≤ 1 and 0 ≤ y ≤ 2), Zn₂₋ₓS_{y}Se_{2-y} (0 ≤ x ≤ 1 and 0 ≤ y ≤ 2), and Sn₂₋ₓS_{y}Se_{2-y} (0 ≤ x ≤ 1 and 0 ≤ y ≤ 2).

12. The method for producing a compound semiconductor thin film according to any of claims 1 to 4, wherein the compound nanoparticles are synthesized at -67°C or higher and 25°C or lower.

13. The method for producing a compound semiconductor thin film according to any of claims 1 to 4, wherein the compound nanoparticles have an average particle size of 1 nm or more and 500 nm or less.

14. A solar cell comprising a compound semiconductor thin film produced by the method for producing a compound semiconductor thin film according to any of claims 1 to 4.
